(19) Europäisches Patentamt
European Patent Office
Office européen des brevets

(11) EP 0 457 069 B1

(12) **EUROPÄISCHE PATENTSCHRIFT**

(45) Veröffentlichungstag und Bekanntmachung des Hinweises auf die Patenterteilung:
**26.02.1997 Patentblatt 1997/09**

(51) Int Cl.[6]: **G01R 33/46**

(21) Anmeldenummer: **91106643.9**

(22) Anmeldetag: **25.04.1991**

(54) **Verfahren und Vorrichtung zur Kompensation von unerwünschten Seitenbändern bei magnetischen Kernresonanzspektren**

Method and apparatus for the compensation of undesirable sidebands in nuclear magnetic resonance spectra

Procédé et dispositif pour la compensation de bandes latérales non voulues dans des spectres de résonance magnétique nucléaire

(84) Benannte Vertragsstaaten:
**CH DE FR GB LI**

(30) Priorität: **10.05.1990 DE 4015056**
**13.06.1990 DE 4018836**

(43) Veröffentlichungstag der Anmeldung:
**21.11.1991 Patentblatt 1991/47**

(73) Patentinhaber: **SPECTROSPIN AG**
**CH-8117 Fällanden (CH)**

(72) Erfinder:
- **Marek, Daniel, Dr.**
  **CH-5115 Möriken (CH)**
- **Kuster, Anton**
  **CH-8606 Greifensee (CH)**
- **Kasten, Arne, Dr.**
  **W-7500 Karlsruhe (DE)**
- **Tschopp, Werner H., Dr.**
  **CH-8127 Forch (CH)**

(74) Vertreter: **KOHLER SCHMID + PARTNER**
**Patentanwälte**
**Ruppmannstrasse 27**
**70565 Stuttgart (DE)**

(56) Entgegenhaltungen:
**JP-A- 2 112 778** **US-A- 4 628 263**
**US-A- 4 734 648**

- **PATENT ABSTRACTS OF JAPAN vol. 13, no. 185 (P-865)2. Mai 1989 & JP-A-1 013 444 ( HITACHI LTD ) 18. Januar 1989**
- **JOURNAL OF MAGNETIC RESONANCE, Bd. 83, Nr. 1, Juni 1989, DULUTH, USA Seiten 177 - 182; Y. OGURA, K. SEKIHARA: 'A New Method for Static Imaging of a Rotating Object'**
- **JOURNAL OF MAGNETIC RESONANCE, Bd. 80, 1988, DULUTH, USA Seiten 547 - 552; G.A. MORRIS: 'Compensation of Instrumental Imperfections by Deconvolution Using an Internal Reference Signal'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 457 069 B1

Printed by Jouve, 75001 PARIS (FR)

## Beschreibung

Die Erfindung betrifft ein Verfahren und eine Vorrichtung zur Kompensation von unerwünschten Seitenbändern bei magnetischen Kernresonanzspektren.

Zur Aufnahme von hochaufgelösten Spektren bei der Kernresonanzspektrometrie (nachfolgend NMR-Spektrometrie genannt) wird die zu messende Probe im Gleichmagnetfeld einer Rotationsbewegung unterworfen, um bestimmte Anteile der Inhomogenitäten des Gleichmagnetfeldes auszumitteln und dadurch eine bessere Auflösung der Spektrallinien zu erreichen. Bedingt durch diese Rotationsbewegung werden jedoch im Spektrum unerwünschte Seitenbänder, die sogenannten Rotationsseitenbänder erzeugt. Diese erscheinen auf beiden Seiten der jeweiligen realen NMR-Spektrallinie in Abständen von Vielfachen der Frequenz der Rotationsbewegung.

Die Entstehung dieser Rotationsseitenbänder hat im wesentlichen drei Ursachen:

- die Inhomogenitäten des statischen Magnetfeldes B0 innerhalb des aktiven Probenvolumens, die sogenannten BO-Inhomogenitäten, welche zusammen mit einer Rotationsbewegung der Probe zu einer Modulation der Präzessionsfrequenz der Kerne führt. B0-Inhomogenitäten können durch den felderzeugenden Magneten selbst, aber auch durch ferro-, dia- oder paramagnetische Materialien in der Umgebung der Probe verursacht werden;

- die Inhomogenitäten des Hochfrequenzfeldes B1, die sogenannten B1-Inhomogenitäten, die von der Sende- und Empfangsspule innerhalb des aktiven Probenvolumens während der Sendephase erzeugt werden und während der Empfangsphase das in die Empfangsspule induzierte Kernsignal mit beeinflussen; und

- die nicht-ideale Rotationsbewegung der Probe, die zum einen durch eine verschobene und/oder gegenüber der Rotationsachse verdrehte Symmetrieachse der Probe und andererseits dadurch, daß die Probenküvette keine idealen rotationssymmetrischen Abmessungen hat, verursacht werden kann. Beide Ursachen haben zur Folge, daß sich im wesentlichen die Streukapazität zwischen Probe und Hochfrequenzempfangsspule periodisch mit der Rotationsfrequenz ändert. Da diese Streukapazität mit zur bereits sehr kleinen Kapazität des Empfangsschwingkreises gezählt werden muß, entsteht dadurch eine periodische Verstimmung des Schwingkreises und damit eine Phasenmodulation des Kernsignales. Außerdem kann diese nicht-ideale Rotationsbewegung bei einer Probe, die Hochfrequenzverluste verursacht, zu einer periodischen Änderung der Dämpfung des Empfangsschwingkreises und damit auch zu einer Amplitudenmodulation des Kernsignales führen. Diese Phasen- und Amplitudenmodulation, die durch die nicht-ideale Rotationsbewegung der Probe hervorgerufen wird, nennt man Q-Modulation. Diese ist besonders bei hohen Frequenzen oberhalb 400 MHz störend, wo der Empfangsschwingkreis nur einen sehr kleinen Kapazitätswert aufweist und deshalb Einflüsse von Störkapazitäten eine große Rolle spielen.

Zum besseren Verständnis werden anhand der Figuren 1 und 2 das Phänomen und die Ursachen der Rotationsseitenbänder erläutert.

Die Fig. 1a zeigt einen typischen Verlauf des Hauptbandes A mit den zugehörigen Rotationsseitenbändern B, B' und C, C' einer Spektrallinie. Die Rotationsseitenbänder lassen sich entsprechend den drei oben beschriebenen Ursachen in ihre jeweiligen Komponenten zerlegen.

Die Fig. 1b stellt die Komponenten, die durch die B-0-Inhomogenitäten verursacht werden, dar. Die Seitenbänder liegen symmetrisch zum Hauptband A und haben die gleiche Phase wie das Hauptband. Dieser experimentelle Befund wird in einem Fachartikel in der Zeitschrift "Journal of Magnetic Resonance 82", Seiten 427 - 433 von H. Levitt theoretisch bestätigt.

Die Fig. 1c zeigt die Komponenten, die durch die obengenannten B-1-Inhomogenitäten verursacht werden. Gemäß dem experimentellen Befund sind die Seitenbänder asymmetrisch zum Hauptband A, liegen meistens aufgrund der Geometrie der Empfangsspule um Vielfache der doppelten Rotationsfrequenz $\omega_m$ vom Hauptband A entfernt und haben ebenfalls die gleiche Phase wie das Hauptband A.

Die Fig. 1d zeigt die durch die Q-Modulation verursachten Seitenbandkomponenten. Die Seitenbandkomponenten sind antisymmetrisch zum Hauptband und können eine beliebige Phase zum Hauptband besitzen. Die Antisymmetrie ist eine Folge der hauptsächlich kapazitiven periodischen Verstimmung des Empfangsschwingkreises, welche hauptsächlich eine Phasenmodulation des Kernsignales zur Folge hat.

Die Fig. 2 zeigt, wie aus einer periodischen Verstimmung $\Delta\omega$ des Empfangsschwingkreises eine Amplitudenmodulation AM und eine Phasenmodulation $\phi$M des Kernsignales K entsteht. Da die Modulationsfrequenz klein gegenüber der Bandbreite des Schwingkreises ist, kann eine quasi stationäre Betrachtungsweise, wie sie in Fig. 2 dargestellt ist, verwendet werden. Man erhält eine Amplitudenmodulation a(t) mit der doppelten Modulationsfrequenz, die aber bei kleinem Modulationshub vernachlässigt werden kann (Fig. 2a).

Störender ist die in Fig. 2b gezeigte Phasenmodulation $\phi$M, die mit der einfachen Modulationsfrequenz auftritt.

Im Stand der Technik hat man zur Verringerung der unerwünschten Rotationsseitenbänder verschiedene apparative Maßnahmen vorgeschlagen, die die Ursache der Rotationsseitenbänder am Ort ihrer Entstehung vermeiden sollen.

Zu diesen bekannten Maßnahmen gehört die Verbesserung der Homogenität des statischen Magnetfeldes B0, beispielsweise durch umfangreiche und genaue Korrekturspulen (Shimspulen-Systeme). Diese Korrektursysteme können jedoch die Inhomogenitäten des statischen Magnetfeldes, die von der magnetischen Suszeptibilität der Hochfrequenzempfangsspule herrühren, nicht zufriedenstellend kompensieren. Dies kann nur durch spezielle Materialwahl für die Hochfrequenzempfangsspule mit verschwindend kleinen Suszeptibilitätswerten erreicht werden.

Zur Verbesserung der B1-Homogenität wurde im Stand der Technik vorgeschlagen, die Geometrie der Hochfrequenzempfangsspule auf beste Feldhomogenität zu optimieren.

Das Problem der Q-Modulation ließ sich jedoch mit solchen Maßnahmen nicht beseitigen. Durch die im Laufe der Zeit anwachsenden Feldstärken des statischen Magnetfeldes bei der magnetischen Kernresonanzspektrometrie wuchsen auch die durch die nicht-ideale Rotationsbewegung der Probe hervorgerufenen unerwünschten Seitenbandkomponenten (Q-Modulation). Die durch die Q-Modulation hervorgerufenen unerwünschten Seitenbänder ließen sich nur durch Verbesserung der mechanischen Präzision der die Rotationsbewegung beeinflussenden Teile (Probenküvette, Läufer, Luftturbine) minimieren. Hier gelangte man jedoch an die Grenze der erreichbaren Präzision.

Aus "Journal of Magnetic Resonance 80, Seiten 547 - 552, (1988) ist ein Verfahren zur nachträglichen Kompensation von Gerätefehlern durch Entfaltung (Deconvolution) unter Verwendung eines internen Bezugssignales beschrieben. Mittels digitaler Filter wird ein Bezugssignal extrahiert, mit dem ein idealisiertes Spektrum durch die genannte Entfaltungstechnik erzeugt wird. Die in diesem Fachartikel vorgeschlagenen Maßnahmen lassen sich auch zur nachträglichen Eliminierung von Rotations-Seitenbändern verwenden.

Mit den im Stand der Technik vorgeschlagenen apparativen Maßnahmen zur Verringerung der Rotationsseitenbänder erreicht man relativ leicht Seitenbandintensitäten von etwa 10 % der Hauptband-Intensität, aber es ist oft sehr schwierig, diesen Wert noch weiter auf die gewünschte Größe von kleiner als 1 % zu bringen. Dies gilt ganz besonders für die durch die Q-Modulation hervorgerufenen Seitenbandkomponenten.

Man kann jedoch davon ausgehen, daß die im Stand der Technik erreichten Seitenbandintensitäten bereits klein gegenüber den Hauptbandintensitäten sind.

Aus der DE-AS 28 16 225, insbesondere Anspruch 1, Fig. 3 und Beschreibungsspalte 2, Zeile 25 bis 64 ist ein Verfahren und eine Vorrichtung bekannt, die die Seitenbänder eines Kernresonanzspektrums, die durch die Rotation der Probe des Kernresonanzspektrometers hervorgerufen werden, über einen bestimmten Frequenzbereich verschmiert. Dadurch entsteht anstatt einer scharfen Seitenbandkomponente mit großer Amplitude eine breite Komponente mit kleiner Amplitude. Das Integral der Seitenbandkomponente ist aber jeweils gleich groß. Somit führt das bekannte Verfahren keine Kompensation der Rotationsseitenbänder durch; die Seitenbänder werden nicht eliminiert sondern erscheinen als breit gezogener Hügel.

Die US-Patentschrift 4 628 263 beschreibt ein Kernspinresonanz-Spektrometer, das eine Einrichtung zum Bestimmen der Winkelstellung eines Proberöhrchens und eine Einrichtung zum Addieren von FID Signalen aufweist. Die HF-Pulse werden gemäß dem Ausgangssignal der Bestimmungseinrichtung angewendet, wenn eine bestimmte Stelle des Probenröhrchen sich an einer ersten bestimmten Position befindet und wenn diese bestimmte Position diametral gegenüber der ersten Position liegt. Die zwei FID Signale, die auf diese Weise gewonnen werden, werden mittels der Addierungseinrichtung addiert, um Rotations-Seitenbänder zu unterdrücken, die an Positionen von den Peakwerten eines NMR-Spektrums mit einem Frequenzbetrag gleich der Rotationsfrequenz des Probenröhrchens bzw. einem ganzzahligen Vielfachen davon verschoben worden sind, wenn die Rotationsachse des Proberöhrchens mit der zentralen Line der Probe nicht übereinstimmt.

Es ist Aufgabe der Erfindung, ein Verfahren und eine Vorrichtung zur Kompensation von unerwünschten Seitenbändern bei magnetischen Kernresonanzspektren zu ermöglichen, mit welchen, ausgehend von den mit den im Stand der Technik vorgeschlagenen apparativen Maßnahmen erzielten Intensitäten der Rotationsseitenbänder, diese Seitenbänder noch weiter reduziert werden können.

Die obige Aufgabe wird bei einem Verfahren zur Kompensation von mindestens einer Art von NMR-Seitenbändern ($H_0$-, $H_1$-, Q-Modulationsseitenbänder), die durch Rotation der Probe eines magnetischen Kernresonanzspektrometers hervorgerufen werden, erfindungsgemäß durch folgende Schritte gelöst:

- Erfassen der Rotationsfrequenz und Phase der Probenrotation;
- Modulation der Amplitude und Phase des detektierten Kernsignals, wobei die Modulationssignale aus mehreren Komponenten zusammengesetzt sind,

wobei

im Falle der Q-Modulationskompensation die Modulationssignale phasenstarr mit der Probenrotation synchronisiert sind, und im Falle der $H_0$- und $H_1$- Seitenbandkompensation die Frequenzen der Modulationskomponenten gleich der Rotationsfrequenz der Probe und ganzzahlige Vielfache davon sind, die Phasen dieser Komponenten je in einem festen Verhältnis zur Phase der Probenrotation stehen und der Start des Senderpulses oder der Pulssequenz zur

Anregung des Kernsignals phasensynchron mit dem Modulationssignal ist.

Vorteilhafterweise wird dieses Verfahren dadurch ausgestaltet, daß für den Modulationsschritt die Amplitude und die Phase der einzelnen Frequenzkomponenten getrennt eingestellt, die so eingestellten Frequenzkomponenten addiert und der Amplitudenund Phasenmodulation zugeführt werden.

Alternativ dazu können vorteilhafterweise für den Modulationsschritt vorab mehrere Kosinus- und Sinussignale mit Frequenzen gleich einem ganzzahligen Vielfachen der Rotationsfrequenz der Probe erzeugt, deren Amplituden auf die jeweiligen zur Kompensation erforderlichen Amplituden gesetzt, und die so erzeugten und amplitudengerichteten Kosinus- und Sinussignale addiert und der Amplituden- und Phasenmodulation zugeführt werden.

Die Modulationssignale können auch in einem digitalen Frequenzgenerator durch Vorgabe der entsprechenden Koeffizienten erzeugt werden.

Erfindungsgemäß kann eines oder mehrere der die obige Aufgabe lösenden Verfahren zum Erzielen von Kernresonanzspektren, die weitgehend frei von Seitenbändern sind, verwendet werden, wobei in einem Rechner die Amplituden- und Phasenmodulation durch Multiplikation des dem Spektrum entsprechenden komplexen Zeitsignals mit einem komplexen Faktor $A(t)\ e^{j\phi(t)}$ durchgeführt wird, wobei A(t) die Zeitfunktion der Amplitudenmodulation und $\phi$ (t) die Zeitfunktion der Phasenmodulation sind.

Eine die obige Aufgabe lösende Vorrichtung zur Kompensation von mindestens einer Art von NMR-Seitenbändern ($H_0$-, $H_1$-, Q-Modulations-Seitenbänder), die durch Rotation der Probe eines magnetischen Kernresonanzspektrometers hervorgerufen werden, ist mit

- einer Sende- und Empfangsspule, die im Gleich-Magnetfeld, die rotierende Probe umgreifend, angeordnet ist, von einem Probenkopf ein Hochfrequenzsignal empfängt und dieses auf die Probe einstrahlt sowie das daraufhin von der Probe emittierte Kernsignal empfängt und zum Probenkopf überträgt; und
- einer Signalerzeugungs- und -Auswerteeinrichtung, die das dem Probenkopf zuzuführende Hochfrequenzsignal erzeugt und aus dem vom Probenkopf empfangenen Kernsignal das Spektrum erzeugt,
- einer Detektoranordnung zur Erfassung von Frequenz und Phase der Rotationsbewegung der Probe,

ausgestattet und
ist erfindungsgemäß gekennzeichnet durch

- einen Kompensationsgenerator, der Signale entsprechend der von der Detektoranordnung erfaßten Frequenz und Phase der Rotationsbewegung der Probe empfängt und in Abhängigkeit von diesen Signalen Amplituden- und Phasenmodulationssignale zur Modulation der Amplitude und Phase des von der Probe abgegebenen und vom Probenkopf detektierten Kernsignals erzeugt, wobei die Modulationssignale aus mehreren Komponenten zusammengesetzt sind,
- einen Amplitudenmodulator, der das erfaßte Kernsignal mit dem vom Kompensationsgenerator erzeugten Modulationssignal amplitudenmoduliert,
- einen Phasenmodulator, der das erfaßte Kernsignal mit dem vom Kompensationsgenerator erzeugten Modulationssignal phasenmoduliert,

wobei

- im Falle der Q-Modulationskompensation die Modulationssignale phasenstarr mit der Probenrotation synchronisiert sind, und
- im Falle der $H_0$- und $H_1$-Seitenbandkompensation die Frequenzen der Modulationskomponenten gleich der Rotationsfrequenz der Probe und ganzzahlige Vielfache davon sind, die Phasen dieser Komponenten je in einem festen Verhältnis zur Phase der Probenrotation stehen und der Start des Senderpulses oder der Pulssequenz zur Anregung des Kernsignals phasensynchron mit dem Modulationssignal ist.

In einer vorteilhaften Ausführungsform weist der Kompensationsgenerator auf:

- jeweils für jedes zu kompensierende Seitenbandpaar zwei kontinuierlich und getrennt einstellbare Phasenschieber und zwei getrennt einstellbare Dämpfungsglieder, jeweils zur getrennten Einstellung von Phase und Amplitude der dem Phasen- und Amplitudenmodulator zuzuführenden Signale.

In einer bevorzugten Ausführungsform weist der Kompensationsgenerator auf:

- für jedes zu kompensierende Seitenbandpaar jeweils einen Oszillatormodul zur Erzeugung von Kosinus- und Sinussignalen mit Frequenzen gleich einem ganzzahligen Vielfachen einschließlich der einfachen Rotationsfrequenz

der Probe, wobei jeder Oszillatormodul kontinuierlich einstellbare Dämpfungsglieder zur Einstellung der erforderlichen Amplitude jedes Sinus- und Kosinussignales,
einen festen 90°-Phasenschieber, der aus den Sinussignalen die Kosinussignale ableitet und für jedes Dämpfungsglied einen Polaritätsumschalter aufweist, und
- Additionsglieder zur Addition jeweils der von den Polaritätsumschaltern abgegebenen Sinus- und Kosinussignale, wobei die Ausgangssignale der Additionsglieder jeweils dem Amplituden- und Phasenmodulator zugeführt werden.

Der Kompensationsgenerator kann auch ein digitaler Frequenzgenerator sein, der die Modulationssignale für die Amplituden- und Phasenmodulation durch Vorgabe der entsprechenden Koeffizienten erzeugt.

Das erfindungsgemäß vorgeschlagene Verfahren und die Vorrichtung gestatten es vorteilhafterweise, die Amplitude und Phase der Rotationsseitenbänder einzeln auf gewünschte Werte einzustellen, so daß ohne Schwierigkeiten Intensitäten der Rotationsseitenbandkomponenten von unter 1 % der Hauptband-Intensität erreicht werden können.

Die Erfindung wird im folgenden in Ausführungsbeispielen anhand der Zeichnung näher erläutert. Es zeigen:

Fig. 3 Diagramme, die den Einfluß einer Amplituden- und Phasenmodulation des Kernsignales auf das Frequenzspektrum erläutern;

Fig. 4 Diagramme, die eine erste Art zur Erzeugung der Signale für die Amplituden- und Phasenmodulation erläutern;

Fig. 5 Diagramme, die eine zweite Art der Erzeugung der Signale für die Amplituden- und Phasenmodulation erläutern;

Fig. 6 Diagramme, die die Kompensation der Grundfrequenz der Q-Modulation erläutern;

Fig. 7 eine Ausführungsform einer Schaltungsanordnung zur Kompensation der Rotationsseitenbänder; und

Fig. 8 ein Blockschaltbild einer Ausführungsart des in Fig. 7 gezeigten Kompensationsgenerators.

Bevor nun das erfindungsgemäße Verfahren und die Vorrichtung zur Kompensation von unerwünschten Seitenbändern bei magnetischen Kernresonanzspektren beschrieben wird, sollen das Prinzip der Modulation des empfangenen Kernsignales und der Einfluß der Amplituden- und Phasenmodulation des Kernsignales auf das Spektrum anhand der Fig. 3 beschrieben werden.

Das Kernsignal ohne Rotationsseitenbänder, wie es vom Empfangsschwingkreis geliefert wird, läßt sich durch

$$y_1\ (t) = A \cdot e^{-\frac{t}{T_2}} \cos(\omega_o t + \varphi_o) \qquad (1)$$

ausdrücken.

Dieses Signal soll sowohl einer Amplitudenmodulation AM wie auch einer Phasenmodulation $\phi$M unterworfen werden.

Für die Amplitudenmodulation gilt:

$$a(t) = 1 + \Delta a(t) = 1 + \Delta a \cos\ (\omega t + \varphi_1) \qquad (2)$$

Für die Phasenmodulation $\phi$M gilt:

$$\Delta\varphi\ (t) = \Delta\varphi \sin\ (\omega_m t + \varphi_2) \qquad (3)$$

Das modulierte Kernsignal ergibt sich zu:

$$y_2 = A\ e^{-\frac{t}{T_2}} [1 + \Delta a(t)]\cos[\omega_o t + \varphi_o + \Delta\varphi(t)]$$

Wenn man kleine Modulationshübe benutzt, d. h. wenn $|\Delta\varphi(t)|^2 << 1$, dann gilt

$$y_2(t) = Ae^{-\frac{t}{T_2}}[1+\Delta a(t)]\left\{\cos(\omega_o t+\varphi_o)-\Delta\varphi(t)\sin(\omega_o t+\varphi_o)\right\}$$

wenn zusätzlich $|\Delta a(t)\cdot\Delta\varphi(t)| << 1$ dann gilt:

$$y_2(t) = Ae^{-\frac{t}{T_2}}\left\{\cos(\omega_o t+\varphi_o)+\Delta a(t)\cos(\omega_o t+\varphi_o) -\Delta\varphi(t)\sin(\omega_o t+\varphi_o)\right\}$$

$$y_2(t) = Ae^{-\frac{t}{T_2}}\left\{\cos(\omega_o t+\varphi_o)+\Delta a\cos(\omega_o t+\varphi_o)\cos(\omega_m t+\varphi_1) -\Delta\varphi\sin(\omega_o t+\varphi_o)\sin(\omega_m t+\varphi_2)\right\}$$

$$\begin{aligned} y_2(t) &= Ae^{-\frac{t}{T_2}}\cos(\omega_o t+\varphi_o) \\ &+Ae^{-\frac{t}{T_2}}\frac{\Delta a}{2}\left\{\cos[(\omega_o+\omega_m)t+\varphi_o+\varphi_1]+\cos[(\omega_o-\omega_m)t+\varphi_o-\varphi_1]\right\} \\ &+Ae^{-\frac{t}{T_2}}\frac{\Delta\varphi}{2}\left\{\cos[(\omega_o+\omega_m)t+\varphi_o+\varphi_2]-\cos[(\omega_o-\omega_m)t+\varphi_o-\varphi_2]\right\} \end{aligned}$$

Im Empfänger wird dieses Signal auf eine Zwischenfrequenz abwärtsgemischt und dort einer Quadraturdetektion zugeführt. Es entstehen zwei niederfrequente Signale $y_A(t)$ und $y_B(t)$, die orthogonal zueinander liegen, und Frequenzen um $\omega_s$ besitzen:

$$\begin{aligned} y_A(t) &= Ae^{-\frac{t}{T_2}}\cos(\omega_s t+\varphi_o) \\ &+Ae^{-\frac{t}{T_2}}\frac{\Delta a}{2}\left\{\cos[(\omega_s+\omega_m)t+\varphi_o+\varphi_1]+\cos[(\omega_s-\omega_m)t+\varphi_o-\varphi_1]\right\} \\ &+Ae^{-\frac{t}{T_2}}\frac{\Delta\varphi}{2}\left\{\cos[(\omega_s+\omega_m)t+\varphi_o+\varphi_2]-\cos[(\omega_s-\omega_m)t+\varphi_o-\varphi_2]\right\} \end{aligned}$$

$$y_B(t) = Ae^{-\frac{t}{T_2}} \sin(\omega_s t + \varphi_o)$$
$$+ Ae^{-\frac{t}{T_2}} \frac{\Delta a}{2} \left\{ \sin[(\omega_s + \omega_m)t + \varphi_o + \varphi_1] + \sin[(\omega_s - \omega_m)t + \varphi_o - \varphi_1] \right\}$$
$$+ Ae^{-\frac{t}{T_2}} \frac{\Delta \varphi}{2} \left\{ \sin[(\omega_s + \omega_m)t + \varphi_o + \varphi_2] - \sin[(\omega_s - \omega_m)t + \varphi_o - \varphi_2] \right\}$$

Betrachtet man $y_A$ (t) als den Realteil und $y_B$ (t) als den Imaginärteil eines komplexen Zeitsignals $\bar{y}_3$ (t), und beachtet man ferner die Beziehung

$$\cos\alpha + j\sin\alpha = e^{j\alpha}$$

dann erhält man:

$$\overline{y_3} = Ae^{-\frac{t}{T_2}} e^{j(\omega_s t + \varphi_o)}$$
$$+ Ae^{-\frac{t}{T_2}} \frac{\Delta a}{2} \left\{ e^{j[(\omega_s + \omega_m)t + \varphi_o + \varphi_1]} + e^{j[(\omega_s - \omega_m)t + \varphi_o - \varphi_1]} \right\} \quad (4)$$
$$+ Ae^{-\frac{t}{T_2}} \frac{\Delta \varphi}{2} \left\{ e^{j[(\omega_s + \omega_m)t + \varphi_o + \varphi_2]} - e^{j[(\omega_s - \omega_m)t + \varphi_o - \varphi_2]} \right\}$$

Im Rechner wird eine Fouriertransformation an dieser komplexen Funktion ausgeführt, wobei das komplexe Signal $\bar{F}_3(\omega)$ im Frequenzbereich entsteht:

$$\bar{F}_3(\omega) = AT_2 e^{j\varphi_o} [a_o(\omega) - jd_o(\omega)] \quad \Big\} \text{ Hauptband}$$
$$\left.\begin{array}{l} + AT_2 \frac{\Delta a}{2} e^{j(\varphi_o + \varphi_1)} [a_{+1}(\omega) - jd_{+1}(\omega)] \\ + AT_2 \frac{\Delta a}{2} e^{j(\varphi_o - \varphi_1)} [a_{-1}(\omega) - jd_{-1}(\omega)] \end{array}\right\} \text{Seitenbänder der Amplitudenmodulation} \quad (5)$$
$$\left.\begin{array}{l} + AT_2 \frac{\Delta \varphi}{2} e^{j(\varphi_o + \varphi_2)} [a_{+1}(\omega) - jd_{+1}(\omega)] \\ - AT_2 \frac{\Delta \varphi}{2} e^{j(\varphi_o - \varphi_2)} [a_{-1}(\omega) - jd_{-1}(\omega)] \end{array}\right\} \text{Seitenbänder der Phasenmodulation.}$$

wobei a(ω) das Absorptionssignal und d(ω) das Dispersionssignal bedeuten:

$$a(\omega)=\frac{1}{1+[(\omega-\omega_R)T_2]^2} \tag{6}$$

$$d(\omega)=\frac{(\omega-\omega_R)T_2}{1+[(\omega-\omega_R)T_2]^2} \tag{7}$$

Die Indizes 0, +1 und -1 von a(ω) und d(ω) in Gleichung (5) bedeuten jeweils

$$\omega_R = \omega_S,\ \omega_R = \omega_S + \omega_m \text{ bzw. } \omega_R = \omega_S - \omega_m.$$

Im Rechner wird die HF-Phase $\varphi_o$ dadurch kompensiert, das $\bar{F}_3(\omega)$ mit $e^{-j\varphi_o}$ komplex multipliziert wird. Es entsteht das phasenkorrigierte Signal $\bar{F}_4(\omega)$:

$$\begin{aligned}
\bar{F}_4(\omega) = {} & AT_2\,[a_0(\omega)-jd_0(\omega)] && \Big\}\ \text{Hauptband}\\
& +AT_2\,\frac{\Delta a}{2}\,e^{j\varphi_1}\,[a_{+1}(\omega)-jd_{+1}(\omega)] && \\
& +AT_2\,\frac{\Delta a}{2}\,e^{-j\varphi_1}\,[a_{-1}(\omega)-jd_{-1}(\omega)] && \Big\}\ \text{Seitenbänder der Amplitudenmodulation}\\
& +AT_2\,\frac{\Delta\varphi}{2}\,e^{j\varphi_2}\,[a_{+1}(\omega)-jd_{+1}(\omega)] && \\
& -AT_2\,\frac{\Delta\varphi}{2}\,e^{-j\varphi_2}\,[a_{-1}(\omega)-jd_{-1}(\omega)] && \Big\}\ \text{Seitenbänder der Phasenmodulation}
\end{aligned}$$

Der Realteil von $\bar{F}_4(\omega)$ sieht wie folgt aus:

$$\begin{aligned}
RF_4(\omega) = {} & AT_2\,a_0(\omega) && \Big\}\ \text{Hauptband}\\
& +AT_2\,\frac{\Delta a}{2}\,[\cos\varphi_1\,a_{+1}(\omega)+\sin\varphi_1\,d_{+1}(\omega)] && \\
& +AT_2\,\frac{\Delta a}{2}\,[\cos\varphi_1\,a_{-1}(\omega)-\sin\varphi_1\,d_{-1}(\omega)] && \Big\}\ \text{Seitenbänder der Amplitudenmodulation}\\
& +AT_2\,\frac{\Delta\varphi}{2}\,[\cos\varphi_2\,a_{+1}(\omega)+\sin\varphi_2\,d_{+1}(\omega)] && \\
& -AT_2\,\frac{\Delta\varphi}{2}\,[\cos\varphi_2\,a_{-1}(\omega)-\sin\varphi_2\,d_{-1}(\omega)] && \Big\}\ \text{Seitenbänder der Phasenmodulation}
\end{aligned} \tag{8}$$

Dieser Realteil ist in Fig. 3 für die Fälle $\varphi_1$, $\varphi_2$ = 0°, 90°, 180° aufgezeichnet.
Bei gleichzeitiger Amplituden- und Phasenmodulation sind die beiden Seitenbänder wie folgt gegeben:

Das obere Seitenband (OSB):

$$OSB = AT_2\left(\frac{\Delta a}{2}\cos\varphi_1 + \frac{\Delta\varphi}{2}\cos\varphi_2\right)a_{+1}(\omega)$$
$$+ AT_2\left(\frac{\Delta a}{2}\sin\varphi_1 + \frac{\Delta\varphi}{2}\sin\varphi_2\right)d_{+1}(\omega) \qquad (9)$$
$$= C_{o1}\,a_{+1}(\omega) + C_{o2}\,d_{+1}(\omega)$$

; und

Das untere Seitenband (USB):

$$USB = AT_2\left(\frac{\Delta a}{2}\cos\varphi_1 - \frac{\Delta\varphi}{2}\cos\varphi_2\right)a_{-1}(\omega)$$
$$- AT_2\left(\frac{\Delta a}{2}\sin\varphi_1 - \frac{\Delta\varphi}{2}\sin\varphi_2\right)d_{-1}(\omega) \qquad (10)$$
$$= C_{u1}\,a_{-1}(\omega) + C_{u2}\,d_{-1}(\omega)$$

;

wobei die Koeffizienten

$$C_{o1} = AT_2\left(\frac{\Delta a}{2}\cos\varphi_1 + \frac{\Delta\varphi}{2}\cos\varphi_2\right)$$
$$C_{o2} = AT_2\left(\frac{\Delta a}{2}\sin\varphi_1 + \frac{\Delta\varphi}{2}\sin\varphi_2\right)$$
$$C_{u1} = AT_2\left(\frac{\Delta a}{2}\cos\varphi_1 - \frac{\Delta\varphi}{2}\cos\varphi_2\right) \qquad (11)$$
$$C_{u2} = -AT_2\left(\frac{\Delta a}{2}\sin\varphi_1 - \frac{\Delta\varphi}{2}\sin\varphi_2\right)$$

sind.

Diese Bezeichnungen und die in Fig. 3 dargestellten Diagramme zeigen, daß unter der Voraussetzung eines kleinen Modulationsgrades sowohl bei der Amplituden- als auch bei der Phasenmodulation eine Modulation mit einer konstanten Modulationsfrequenz jeweils nur zu zwei Seitenbändern führt, die erstens klein gegenüber dem Hauptband sind und zweitens im Falle der Amplitudenmodulation symmetrisch und im Falle der Phasenmodulation antisymmetrisch zum Hauptband liegen.

Mit diesen Modulationsseitenbändern können aber nur dann genaue Kompensationen der Rotationsseitenbänder erreicht werden, wenn letztere ebenfalls klein gegenüber dem Hauptband sind (z. B. weniger als 10 % betragen). Diese Voraussetzung ist aber mit den bekannten Mitteln des heutigen Standes der Technik erfüllbar.

An dieser Stelle sei bemerkt, daß ein sinusförmig phasenmoduliertes Signal theoretisch ein unendlich breites Frequenzspektrum liefert. Im Falle von kleinen Phasenhüben von $\Delta\varphi$, d. h. wenn $(\Delta\varphi)^2$ viel kleiner als 1 ist, reduziert sich jedoch das Spektrum auf nur zwei Seitenbänder zusammen mit einem dominanten Hauptband. Alle übrigen Seitenbänder sind theoretisch immer noch vorhanden, jedoch in ihrer Intensität so klein, daß sie vernachlässigt werden

können.

Es ist leicht zu zeigen, daß mit der erfindungsgemäß vorgeschlagenen Amplituden- und Phasenmodulation des Kernsignales die Amplitude und Phase der beiden Seitenbänder einzeln auf beliebige Werte eingestellt werden können. Betrachtet man nämlich das oben angeführte Gleichungssystem (11), so stellen dessen Gleichungen ein lineares System mit den vier unbekannten $\Delta a$, $\Delta\varphi$, $\varphi_1$, $\varphi_2$ und vier bekannten Größen $C_{o1}$, $C_{o2}$, $C_{u1}$, $C_{u2}$ dar, wobei letztere vier die gewünschten Amplituden der absorptiven und dispersiven Anteile des oberen und unteren Seitenbandes sind. Dieses Gleichungssystem ist lösbar.

Die vorherigen mathematischen Ableitungen und Schlußfolgerungen gelten für den Fall kleiner Phasenänderungen der Phasenmodulation. Die Resultate führen zu einfachen Kompensationsverfahren, indem jedes einzelne Seitenbandpaar für sich kompensiert werden kann, ohne dabei die anderen zu beeinflussen. Dieses Kompensationsverfahren ist aber nur dann anwendbar, wenn die zu kompensierenden Rotationsseitenbänder ebenfalls klein gegenüber dem Hauptband sind. Es ist jedoch wichtig festzuhalten, daß bei großen Rotationsseitenbändern eine Kompensation mit dem erfindungsgemäßen Verfahren immer noch möglich ist, allerdings sehr viel mühsamer, weil die einzelnen Seitenbandpaare nicht mehr unabhängig voneinander kompensiert werden können.

Wie bereits anhand der Fig. 1 ausgeführt wurde, besitzen die Rotationsseitenbänder, die durch B0- und B1-Inhomogenitäten verursacht werden, die gleiche oder entgegengesetzt gleiche Phase wie das Hauptband, d.h. sie weisen eine starre Phasenbeziehung zum Hauptband auf, die unabhängig von der Phase der Rotationsbewegung ist. Diese Eigenschaft muß auch auf die Modulationsseitenbänder übertragen werden, indem der Start des Senderpulses zur Anregung des Kernsignals phasensynchron zum Modulationssignal erfolgt.

Die Rotationsseitenbänder, die durch die Q-Modulation verursacht werden, besitzen eine beliebig verschiedene Phase zum Hauptband und brauchen deshalb nicht unbedingt die oben beschriebene Phasensynchronität. Es ist aber die Phase dieser Seitenbänder direkt mit der Rotation der Probe korreliert, und deshalb muß hier das Modulationssignal zur Kompensation der Seitenbänder unbedingt phasensynchron zur Probenrotation sein. Will man außerdem, daß das NMR-Spektrum samt Seitenbändern nach jeder Pulsanregung gleich bleibt, was den Kompensationsvorgang stark erleichtern würde, dann allerdings ist hier zusätzlich auch noch eine Phasensynchronität zwischen dem Start des Anregungspulses und der Rotationsfrequenz erforderlich.

Anhand der Fig. 4 wird ein vorteilhaftes Verfahren zur Erzeugung der Amplituden- und Phasenmodulationssignale beschrieben.

Die Amplitude und die Phase der einzelnen Frequenzkomponenten werden separat eingestellt. Die einzelnen Frequenzkomponenten werden addiert und jeweils einem Amplituden- und Phasenmodulator zugeführt. Das Kernsignal wird jeweils durch die diesen Modulatoren zugeführten Amplitudenmodulationssignale a(t) und Phasenmodulationssignale $\varphi$ (t) amplituden- und phasenmoduliert. Fig. 4 zeigt deutlich die notwendige Synchronisierung der Phasenlage der einzelnen Frequenzkomponenten mit dem Startpunkt $t_0$ der Signalerfassung.

Zur Realisierung sind pro Seitenbandpaar jeweils zwei kontinuierlich einstellbare Phasenschieber und zwei einstellbare Dämpfungsglieder (Attenuatoren) erforderlich. Um Seitenbänder bis zur dritten Ordnung kompensieren zu können, sind also sechs kontinuierlich einstellbare Phasenschieber und für die Amplitudeneinstellung sechs einstellbare Dämpfungsglieder erforderlich.

In Fig. 5 ist ein bevorzugtes Verfahren, das alternativ zum obigen Verfahren einsetzbar ist, zur Erzeugung der Signale für die Amplituden- und Phasenmodulation veranschaulicht. Dieses Verfahren kommt ohne kontinuierlich einstellbare Phasenschieber aus. Vorab werden Kosinus- und Sinussignale der Frequenzen $\omega_m$, 2 $\omega_m$, 3 $\omega_m$, ... erzeugt, mit einstellbaren Dämpfungsgliedern (Attenuatoren) auf die erforderliche Amplitude eingestellt, addiert und dem Phasen- und Amplitudenmodulator zugeführt. Wenn das Hauptband in Absorption ist, erzeugen Kosinussignale im Amplitudenmodulator symmetrische Absorptionsseitenbänder und im Phasenmodulator antisymmetrische Dispersionsseitenbänder. Umgekehrt erzeugen Sinussignale im Amplitudenmodulator symmetrische Dispersionsseitenbänder und im Phasenmodulator antisymmetrische Absorptionsseitenbänder. Dieser Sachverhalt geht aus der oben angeführten Ableitung der Modulation des Kernsignales und der Darstellung in Fig. 3 hervor. Es können also sowohl symmetrische als auch antisymmetrische Absorptions-und Dispersionsseitenbänder erzeugt werden. Damit lassen sich beliebige Phasen und Amplituden für die oberen und unteren Seitenbänder erreichen.

In Fig. 8 ist eine Ausführungsform eines Kompensationsgenerators gezeigt, der die Modulationssignale gemäß dem zuletzt geschilderten Verfahren erzeugt. Dieses Ausführungsbeispiel ist zur Kompensation von Seitenbändern bis zur dritten Ordnung vorgesehen. Der dargestellte Kompensationsgenerator 18 weist drei phasenstarre Oszillatoren 21, 22 und 23 zur Erzeugung der Grundfrequenzen $\omega_m$, 2 $\omega_m$ und 3 $\omega_m$ auf. Diese Grundfrequenzen werden von der zugeführten Rotationsfrequenz $\omega_m$ abgeleitet und sind mit dieser Frequenz synchronisiert. Die Grundfrequenzen $\omega_m$ 2 $\omega_m$ und 3 $\omega_m$ werden jeweils einem Signalgeneratormodul 31, 32 und 33 zugeführt. Der Aufbau dieser drei Signalgeneratormodule ist prinzipiell derselbe, so daß nur ein Signalgeneratormodul 31 im Detail dargestellt ist. Jeder Signalgeneratormodul weist einen 90° Phasenschieber 35 und vier einstellbare Dämpfungsglieder $34_1$, $34_2$, $34_3$ und $34_4$ auf, die die Signale sin $\omega_m$t und cos $\omega_m$t mit der erforderlichen Amplitude abhängig von ihnen jeweils zugeführten Einstellsignalen S1 bis S4 erzeugen. Die so in ihrer Amplitude und Phasenlage festgelegten Signale sin $\omega_m$t und cos

$\omega_m t$ werden jeweils Polaritätsumschaltern 36 und 37 zugeführt, die je nach ihrem von einem Stellsignal P1 eingestellten Schaltzustand die Sinus- und Kosinussignale sowohl für symmetrisch als auch antisymmetrische Absorptions- und Dispersionsseitenbänder erzeugen. Schließlich werden die Sinus- und Kosinussignale der einzelnen Frequenzen $\omega_m$, $2\omega_m$, $3\omega_m$ in Summiergliedern 40 und 41 summiert. Die Ausgangssignale 43 und 44 jeweils der Summierglieder 40 und 41 werden zum Phasenmodulator und zum Amplitudenmodulator geleitet. Zur Synchronisation des Starts der Signalerfassung im Rechner wird das Signal $\omega_m$, das dem Kompensationsgenerator eingegeben wird, über ein Verstärkerglied 42 dem Rechner als das Signal 45 zugeführt.

Die obige Beschreibung der in Fig. 8 gezeigten Anordnung macht deutlich, daß man ohne kontinuierlich einstellbare Phasenschieber auskommt. Die in Fig. 8 dargestellte Anordnung ermöglicht die Erzeugung sowohl von symmetrischen als auch antisymmetrischen Absorptions- und Dispersionsseitenbändern. Damit lassen sich beliebige Phasen und Amplituden für die oberen und unteren Seitenbänder erreichen. Zur Kompensation von Seitenbändern bis zur dritten Ordnung benötigt man drei feste 90° Phasenschieber zur Erzeugung der drei Sinus und der drei entsprechenden Kosinusfunktionen. Ferner werden pro Modulationsfrequenz vier einstellbare Dämpfungsglieder, insgesamt zwölf Dämpfungsglieder und schließlich pro Dämpfungsglied noch ein Polaritätsumschalter benötigt. Der Vorteil des zweiten Verfahrens, das mit der Schaltung in Fig. 8 realisiert wird, besteht darin, daß keine kontinuierlichen Phasenschieber nötig sind.

Selbstverständlich kann das Modulationssignal auch digital in einem Frequenzgenerator durch Vorgabe der entsprechenden Koeffizienten der Modulationssignale gemäß dem obigen Gleichungssystem 11 erzeugt werden.

Die Fig. 7 zeigt in Form eines Blockschaltbildes eine bevorzugte Ausführungsform einer erfindungsgemäßen Vorrichtung zur Kompensation von unerwünschten Seitenbändern bei magnetischen Kernresonanzspektren. Im einzelnen sind in Fig. 7 gezeigt:

Eine Probe 10, die mittels einer Luftturbine 11 in einem statischen Magnetfeld B0 rotiert. Der Läufer der Luftturbine 11 trägt optische Markierungen, die zur Erfassung der Frequenz und Phase der Rotation der Probe mit Hilfe eines vom Licht fühler 12 ausgesendeten Lichtstrahles dienen. Die Probenküvette ist von einer Sende- und Empfangsspule 6 umgeben, die mit einem Probenkopfnetzwerk 7 verbunden ist. Das Probenkopfnetzwerk 7 erhält von einer Frequenzaufbereitungseinrichtung 17, die von einem quarzstabilisierten Basisoszillator 1 angesteuert wird, das Hochfrequenz-Sendesignal 4. Dieses wird über ein Verstärkungsglied 5 dem Probenkopfnetzwerk 7 zugeführt. Das vom Probenkopfnetzwerk 7 empfangene Kernresonanzsignal wird über einen Vorverstärker 8 einem Amplitudenmodulator 13 zugeführt, mit dem die Amplitudenmodulation gemäß dem vorgeschlagenen Verfahren durchgeführt wird. Das so amplitudenmodulierte Kernsignal wird einem Überlagerungsempfänger 9 mit Quadraturdetektion zugeführt. Ein Kompensationsgenerator 18 erhält von einem Lichtempfänger 12 Signale 19 über die Frequenz und Phase der Rotationsbewegung der Probe 10. Abhängig von den Signalen 19 erzeugt ein Kompensationsgenerator 18 die Amplitudenmodulationssignale 44 und die Phasenmodulationssignale 43, welche jeweils dem Amplitudenmodulator 13 und einem Phasenmodulator 14 zugeführt werden. Der Phasenmodulator 14 moduliert mit Hilfe des empfangenen Phasenmodulationssignales 43 die Phase des Kernsignales im Empfänger 9, bevor dieses der Quadraturdetektion zugeführt wird. Ferner empfängt der Phasenmodulator 14 ein Signal 3 von einem Lokaloszillator innerhalb der Frequenzaufbereitungseinrichtung 17. Der Kompensationsgenerator 18 führt außerdem das Signal 45, das die Phasenlage des Rotationssignals $\omega_m$ angibt, zu einem Rechner 16, der vom Empfänger 9 das aufgrund der Quadraturdetektion in Real- und Imaginärteil aufgespaltene Kernsignal empfängt. Schließlich liefert der Rechner 16 ein Triggersignal für den HF-Sendeimpuls an die Frequenzaufbereitungseinrichtung 17.

Der Kompensationsgenerator 18 hat bevorzugt die in Fig. 8 dargestellte Anordnung. Er erhält von außen weitere Signale zur Kompensationseinstellung.

Selbstverständlich ist die in Fig. 7 dargestellte Lage des Amplitudenmodulators 13 und des Phasenmodulators 14 nicht zwingend. Diese Modulatoren können praktisch an beliebigen geeigneten Stellen im Empfangsweg eingebaut werden. Insbesondere können diese Modulatoren auch direkt am Empfangsschwingkreis angebracht werden. Beispielsweise kann der Phasenmodulator mit Hilfe einer Kapazitätsdiode realisiert werden, die den Schwingkreis periodisch verstimmt und dadurch eine Phasenmodulation erzeugt. Der Amplitudenmodulator kann mittels einer Diode realisiert werden, deren Arbeitspunkt periodisch verändert wird, wodurch eine periodische Dämpfung des Schwingkreises bewirkt wird. Außerdem läßt sich der Phasenmodulator sowohl in einen beliebigen Lokal-Oszillatorweg, wie auch in den Empfangspfad, z. B. unmittelbar nach dem Amplitudenmodulator 13, einbauen. Man kann aber auch die Phasen- und Amplitudenmodulation direkt am Empfangsschwingkreis erzeugen, indem dessen Resonanzfrequenz bzw. dessen Dämpfung moduliert wird. Dieses letztere Verfahren hat den Vorteil, daß die Rotationsseitenbänder unmittelbar nach ihrer Entstehung kompensiert werden, was zu einer zeitlich stabileren Kompensation führen kann. Zudem läßt sich bei diesem Verfahren, allerdings nur im Falle der Q-Modulation, der Kompensationsabgleich ohne Kernsignal ausführen, indem eine Reflexions-Meßbrücke über das Probenkopfnetzwerk an den Empfangsschwingkreis angeschlossen wird. Bei abgeglichener Brücke ist die Messung äußerst empfindlich für kleinste Schwankungen der komplexen Impedanz des Schwingkreises, und damit auch auf die Q-Modulation, so daß letztere leicht auf Null kompensiert werden kann. Man beachte auch, daß das Ergebnis jedes Kompensationsschrittes sofort zur Verfügung steht

und nicht noch rechnerisch transformiert werden muß.

Für die Modulation der Resonanzfrequenz des Empfangsschwingkreises kann z. B. eine Kapazitätsdiode, ein piezokeramisches Plättchen mit beidseitig aufgedampften und kapazitiv wirkenden Metallschichten, oder ein mechanisch angetriebenes Kondensatorplättchen, bei dem die Antriebsfrequenz aus der Probenrotation abgeleitet wird, verwendet werden. Es wäre auch denkbar, die Resonanzfrequenz des Empfangsschwingkreises induktiv zu modulieren, indem eine kurzgeschlossene Leiterschleife, die auf einem piezokeramischen Plättchen montiert ist, in der Nähe der Schwingkreisinduktivität montiert wird. Für die Modulation der Dämpfung des Empfangsschwingkreises kann z. B. eine Diode oder ein Feldeffekttransistor verwendet werden, die durch eine Veränderung ihrer Arbeitspunkte als variable Widerstände wirken können.

Statt der bislang beschriebenen und bevorzugten Erzeugungen der Modulationssignale lassen sich die Funktionen des Amplituden- und Phasenmodulators auch zur Aufbereitung des Spektrums verwenden, indem das komplexe, im Rechner 16 gespeicherte Zeitsignal mit einem komplexen Faktor $A(t) \cdot e^{j\phi(t)}$ multipliziert wird. Dabei bedeuten A(t) die Amplitudenmodulationsfunktion und $\phi$ (t) die Phasenmodulationsfunktion. Jedoch benötigt auch diese Kompensation die kontinuierliche Information der Rotationsfrequenz und der Phase der Rotationsbewegung der Probe. Diese Größen müssen also notwendigerweise bei der Messung des jeweiligen Kernresonanzspektrum mit gemessen und gespeichert werden.

Dieses rechnerische Verfahren hat den Vorteil, daß der Kompensationsvorgang an Hand eines einzigen im Rechner gespeicherten Kernsignals durchgeführt werden kann. Es ist also nicht nötig, nach jedem Kompensationsschritt das Spinsystem neu anzuregen, dann abzuwarten, bis das Kernsignal abgeklungen ist, um dann erst das ganze Signal zur Verfügung zu haben. Außerdem ist es möglich, Kernsignale aus mehreren Anregungen aufzusummieren, dadurch ein besseres Signal/Rausch-Verhältnis zu erhalten, und an dem so gespeicherten und rauscharmen Signal das rechnerische Kompensationsverfahren viel genauer anzuwenden. Wenn zudem der Rechner die Fouriertransformation sehr schnell ausführen kann, dann sieht man praktisch zeitgleich die durch den Abgleichvorgang hervorgerufenen Veränderungen im Frequenzspektrum, und dies bedeutet eine große Vereinfachung.

Auch im Fall der Q-Modulationskompensation werden bei allen erfindungsgemäßen Verfahren die Modulationssignale aus mehreren Komponenten zusammengesetzt, deren Frequenzen gleich der Rotationsfrequenz der Probe und ganzzahlige Vielfache davon sind.

Ausgehend von einem Verfahren zur Kompensation von mindestens einer Art von Seitenbändern ($H_0$-, $H_1$-, Q-Modulations-Seitenbänder), die durch Rotation der Probe eines magnetischen Kernresonanzspektrometers hervorgerufen werden, besteht eine Erfindung auch in folgenden Schritten:

- Erfassen der Rotationsfrequenz ($\omega_m$) und Phase der Probenrotation;
- Modulation der Amplitude und Phase des detektierten Kernsignals, wobei die Modulationssignale aus mehreren Komponenten zusammengesetzt sind, deren Frequenzen gleich der Rotationsfrequenz ($\omega_m$) der Probe und ganzzahlige Vielfache davon sind,
  wobei
- im Falle der Q-Modulationskompensation die Modulationskomponenten phasenstarr mit der Probenrotation synchronisiert sind, und
- im Falle der $H_0$- und $H_1$- Seitenbandkompensation einerseits die Modulationskomponenten phasenstarr mit der Probenrotation sind, und andererseits der Start des Senderpulses oder der Pulssequenz zur Anregung des Kernsignals phasenstarr mit den Modulationskomponenten ist, und
- im Falle der $H_0$- und $H_1$- Seitenbandkompensation, wenn Kernsignale aus mehreren Pulsanregungen aufsummiert werden, einerseits die Phasenbeziehung zwischen den Modulationskomponenten und der Probenrotation bei verschiedenen Aufnahmeperioden verschieden sein darf, aber innerhalb jeder einzelnen Aufnahmeperiode konstant ist,
  und andererseits die Startzeiten des Senderpulses oder der Pulssequenz zur Anregung des Kernsignals und die Modulationskomponenten in einer beliebigen, aber konstanten Phasenbeziehung über alle Anregungsperioden stehen.

Diese Schritte geben an, wie bei einer Kernsignalaufnahme aufgrund eines einzelnen Senderimpulses oder einer einzelnen anregenden Pulssequenz einerseits und bei mehreren Kernsignalen andererseits vorgegangen werden kann. Im Falle der $H_0$- und $H_1$-Seitenbandkompensation müssen somit nur die Frequenzen der Modulationskomponenten stets mit der Rotationsfrequenz der Probe übereinstimmen bzw. ein Vielfaches dieser Rotationsfrequenz sein, wogegen die Phasenlagen zwischen den einzelnen Aufnahmeperioden differieren können. Ein Vorteil dieses selbständig neben den Patentansprüchen 2 und 6 stehenden Verfahrens besteht darin, daß ein zusätzlicher Freiheitsgrad gewonnen wird, weil die Phasenbeziehung zwischen den Modulationskomponenten und der Probenrotation bei verschiedenen Aufnahmeperioden verschieden sein darf, und hierdurch kann möglicherweise die Unterdrückung systematischer Fehler, die bei der Signalsummierung auftreten könnten, erleichtert werden.

## Patentansprüche

1. Verfahren zur Kompensation von Rotationsseitenbändern im Spektrum eines magnetischen Resonanzspektrometers, das in einer rotierenden Probe durch wiederholtes Einstrahlen eines Senderpulses oder einer Pulssequenz angeregt und akkumuliert wird, wobei die Frequenz ($\omega_m$) und Phase der Probenrotation erfaßt wird, gekennzeichnet durch folgenden Schritt:

   - Modulation der Amplitude und Phase des detektierten Kernsignals, wobei die Modulationssignale aus mehreren Komponenten zusammengesetzt sind, deren Frequenzen gleich der Rotationsfrequenz ($\omega_m$) der Probenrotation und ganzzahligen Vielfachen davon und die phasenstarr mit der Probenrotation sind, und wobei über alle Anregungen der Start des Senderpulses oder der Pulssequenz in einer konstanten Phasenbeziehung zu den Modulationssignalen steht.

2. Verfahren nach Anspruch 1, dadurch gekennzeichnet, daß für den Modulationsschritt die Amplitude und die Phase der einzelnen Frequenzkomponenten getrennt eingestellt, die so eingestellten Frequenzkomponenten addiert und der Amplituden- und Phasenmodulation zugeführt werden.

3. Verfahren nach Anspruch 1, dadurch gekennzeichnet, daß für den Modulationsschritt vorab mehrere Kosinus- und Sinussignale mit Frequenzen ($\omega_m$, $2\omega_m$, $3\omega_m$) gleich einem ganzzahligen Vielfachen der Rotationsfrequenz ($\omega_m$) der Probe erzeugt, deren Amplituden auf die jeweiligen zur Kompensation erforderlichen Amplituden eingestellt und die so erzeugten Kosinus- und Sinussignale addiert und der Amplituden- und Phasenmodulation zugeführt werden.

4. Verfahren nach Anspruch 2 oder 3, dadurch gekennzeichnet, daß die Modulationssignale in einem digitalen Frequenzgenerator durch Vorgabe der entsprechenden Koeffizienten erzeugt werden.

5. Verwendung eines oder mehrerer der vorangehenden Verfahren für eine Aufbereitung von Kernresonanzspektren nach deren Erzeugung, dadurch gekennzeichnet, daß in einem Rechner die Amplituden- und Phasenmodulation durch Multiplikation des dem Spektrum entsprechenden komplexen Zeitsignals mit einem komplexen Faktor A (t) $e^{j\phi(t)}$ durchgeführt wird, wobei A (t) die Zeitfunktion der Amplitudenmodulation und $\phi$ (t) die Zeitfunktion der Phasenmodulation ist.

6. Vorrichtung zur Kompensation von Rotationsseitenbändern im Spektrum eines magnetischen Resonanzspektrometers, das in einer rotierenden Probe durch wiederholtes Einstrahlen eines Senderpulses oder einer Pulssequenz angeregt und akkumuliert wird, mit einer Detektoranordnung (12) zum Erfassen der Frequenz ($\omega_m$) und Phase der Probenrotation, gekennzeichnet durch einen Kompensationsgenerator (18), der Modulationssignale zur Modulation der Amplitude und Phase des detektierten Kernsignals erzeugt, wobei die Modulationssignale aus mehreren Komponenten zusammengesetzt sind, deren Frequenzen gleich der Rotationsfrequenz ($\omega_m$) der Probenrotation oder ganzzahligen Vielfachen davon sind und die phasenstarr mit der Probenrotation sowie über alle Anregungen mit dem Start des Senderpulses oder der Pulssequenz synchronisiert sind.

7. Vorrichtung nach Anspruch 6, dadurch gekennzeichnet, daß der Kompensationsgenerator (18) Phasen- und Amplitudeneinstellmittel aufweist umfassend:

   - jeweils für jedes zu kompensierende Seitenbandpaar zwei kontinuierlich und getrennt einstellbare Phasenschieber und
   - zwei getrennt einstellbare Dämpfungsglieder, jeweils zur getrennten Einstellung von Phase und Amplitude der dem Phasen- und Amplitudenmodulator zuzuführenden Signale.

8. Vorrichtung nach Anspruch 6, dadurch gekennzeichnet, daß der Kompensationsgenerator (18) Phasen- und Amplitudeneinstellmittel aufweist umfassend:

   - für jedes zu kompensierende Seitenbandpaar jeweils einen Oszillatormodul (21, 31; 22, 32; 23, 33) zur Erzeugung von Kosinus- und Sinussignale mit Frequenzen gleich einem ganzzahligen Vielfachen einschließlich der einfachen Rotationsfrequenz ($\omega_m$) der Probe, wobei jeder Oszillatormodul kontinuierlich einstellbare Dämpfungsglieder ($34_1$, $34_2$, $34_3$, $34_4$) zur Einstellung der erforderlichen Amplitude jedes Sinus- und Kosinussignales, einen festen 90°-Phasenschieber (35), der aus den Sinussignalen die Kosinussignale ableitet und für jedes Dämpfungsglied einen Polaritätsumschalter (36, 37) aufweist,

und

- Additionsglieder (40, 42) zur Addition jeweils der von den Polaritätsumschaltern abgegebenen Sinus- und Kosinussignale, wobei die Ausgangssignale der Additionsglieder jeweils dem Amplituden- und Phasenmodulator zugeführt werden.

**9.** Vorrichtung nach Anspruch 6, dadurch gekennzeichnet, daß der Kompensationsgenerator (18) als digitaler Frequenzgenerator ausgeführt ist, der die Modulationssignale durch Vorgabe der entsprechenden Koeffizienten erzeugt.

**Claims**

**1.** Method for compensation of rotational side bands in a magnetic resonance spectrometer spectrum excited and accumulated in a rotating sample through repeated irradiation of a transmitter pulse or of a pulse sequence, wherein the frequency ($\omega_m$) and the phase of the sample rotation is measured, characterized by the following step:

- modulation of the amplitude and phase of the detected nuclear signal, wherein the modulation signals are composed from a plurality of components whose frequencies are equal to the rotational frequency ($\omega_m$) of the sample rotation and to integral multiples thereof and which have fixed phase relationship to the sample rotation, and wherein, for all excitations, the start of the transmitter pulse or of the pulse sequence has constant phase relationship to the modulation signals.

**2.** Method according to claim 1, characterized in that, for the modulation step, the amplitude and the phase of the individual frequency components are separately adjusted and the frequency components adjusted in this fashion are added and introduced to the amplitude and phase modulation.

**3.** Method according to claim 1, characterized in that, for the modulation step, a plurality of cosine and sine signals having frequencies ($\omega_m$, $2\omega_m$, $3\omega_m$) equal to an integral multiple of the rotational frequency ($\omega_m$) of the sample are initially produced having amplitudes which are adjusted to the amplitudes necessary for compensation in each case, and the cosine and sine signals produced in this fashion are added and introduced to the amplitude and phase modulation.

**4.** Method according to claim 2 or 3, characterized in that the modulation signals are produced in a digital frequency generator by stipulation of the appropriate coefficients.

**5.** Use of one or a plurality of the preceding methods for the processing of nuclear resonance spectra following their production, characterized in that the amplitude and phase modulations are carried out in a computer through multiplication of the complex time signal corresponding to the spectrum with a complex factor A (t) $e^{j\phi(t)}$, wherein A (t) is the time function of the amplitude modulation and $\phi(t)$ is the time function of the phase modulation.

**6.** Apparatus for compensation of rotational side bands in a magnetic resonance spectrometer spectrum excited and accumulated in a rotating sample through repeated irradiation of a transmitter pulse or of a pulse sequence, having a detector configuration (12) for measuring the frequency ($\omega_m$) and phase of the sample rotation, characterized by a compensating generator (18), which produces modulation signals for modulating the amplitude and phase of the detected nuclear signal, wherein the modulation signal is composed from a plurality of components, whose frequencies are equal to the rotational frequency ($\omega_m$) of the sample rotation or to an integral multiple thereof and which have a fixed phase relationship to the sample rotation and are synchronized to the start of the transmitter pulse or of the pulse sequence for all excitations.

**7.** Apparatus according to claim 6, characterized in that the compensating generator (18) has phase and amplitude adjustment means including:

- two continuously and separately adjustable phase shifters for each side band pair to be compensated and

- two separately adjustable attenuation members, each for a separate adjustment of phase and amplitude of the signals to be introduced into the phase and amplitude modulator.

8. Apparatus according to claim 6, characterized in that the compensating generator (18) has phase and amplitude adjustment means including:

- an oscillator module (21, 31; 22, 32; 23,33) for each side band pair to be compensated to produce cosine and sine signals having frequencies equal to the rotational frequency ($\omega_m$) of the sample and to integral multiples thereof, wherein each oscillator module has continuously adjustable attenuation members ($34_1$, $34_2$, $34_3$, $34_4$) for adjustment of the required amplitude of each sine and cosine signal, a fixed 90° phase shifter (35) which derives the cosine signals from the sine signals and a polarity switcher (36, 37) for each attenuation member, and

- addition members (40, 42) for respective addition of the sine and cosine signals from the polarity switchers, wherein the output signals of the addition members are introduced to the amplitude and phase modulator in each case.

9. Apparatus according to claim 6, characterized in that the compensating generator (18) is configured as a digital frequency generator, which produces the modulation signals by specification of the appropriate coefficients.

## Revendications

1. Procédé pour compenser des bandes latérales de rotation dans le spectre d'un spectromètre à résonance magnétique qui est excité et accumulé dans un échantillon tournant par irradiation réitérée au moyen d'une impulsion d'émetteur ou d'une séquence d'impulsions, la fréquence ($\omega_m$) et la phase de la rotation de l'échantillon étant détectées, caractérisé par l'étape suivante :

- modulation de l'amplitude et de la phase du signal de noyau détecté, cependant que les signaux de modulation sont constitués à partir de plusieurs composants dont les fréquences sont égales à la fréquence de rotation ($\omega_m$) de la rotation de l'échantillon et à des multiples entiers de celle-ci et qui sont rigides en phase avec la rotation de l'échantillon, et que le départ de l'impulsion d'émetteur ou de la séquence d'impulsions présente une relation de phases constante avec les signaux de modulation sur toutes les excitations.

2. Procédé selon la revendication 1, caractérisé par le fait que l'on règle séparément pour l'étape de modulation l'amplitude et la phase des divers composants de la fréquence, que l'on additionne les composants de la fréquence ainsi réglés, et qu'on les amène à la modulation de l'amplitude et de la phase.

3. Procédé selon la revendication 1, caractérisé par le fait que l'on engendre tout d'abord pour l'étape de modulation plusieurs signaux en sinus et en cosinus dont les fréquences ($\omega_m$, $2\omega_m$, $3\omega_m$) sont égales à un multiple entier de la fréquence de rotation ($\omega_m$) de l'échantillon et dont les amplitudes sont réglées sur les amplitudes qui sont à chaque fois nécessaires pour la compensation, que l'on additionne les signaux en sinus et en cosinus ainsi engendrés, et qu'on les amène à la modulation de l'amplitude et de la phase.

4. Procédé selon la revendication 2 ou 3, caractérisé par le fait que les signaux de modulation sont engendrés dans un générateur de fréquences numérique par la donnée des coefficients correspondants.

5. Utilisation d'un ou plusieurs des procédés précédents pour une préparation des spectres de résonance nucléaire après qu'ils ont été engendrés, caractérisée par le fait que la modulation de l'amplitude et de la phase est réalisée dans un calculateur par multiplication du signal complexe fonction du temps qui correspond au spectre par un facteur complexe $A(t) \cdot e^{j\phi(t)}$, A(t) étant la modulation de l'amplitude en fonction du temps et $\phi(t)$ étant la modulation de la phase en fonction du temps.

6. Dispositif pour compenser des bandes latérales de rotation dans le spectre d'un spectromètre à résonance magnétique qui est excité et accumulé dans un échantillon tournant par irradiation réitérée au moyen d'une impulsion d'émetteur ou d'une séquence d'impulsions, comprenant un dispositif détecteur (12) pour détecter la fréquence ($\omega_m$) et la phase de la rotation de l'échantillon, caractérisé par un générateur de compensation (18) qui engendre des signaux de modulation pour moduler l'amplitude et la phase du signal de noyau détecté, cependant que les signaux de modulation sont constitués à partir de plusieurs composants dont les fréquences sont égales à la fréquence de rotation ($\omega_m$) de la rotation de l'échantillon ou à des multiples entiers de celle-ci et qui sont rigides en phase avec la rotation de l'échantillon, en étant synchronisés avec le départ de l'impulsion d'émetteur ou de la

séquence d'impulsions sur toutes les excitations.

7. Dispositif selon la revendication 6, caractérisé par le fait que le générateur de compensation (18) comporte des moyens de réglage de la phase et de l'amplitude qui comprennent :

- à chaque fois deux déphaseurs pouvant être réglés continûment et séparément pour chaque paire de bandes latérales à compenser ; et :
- deux atténuateurs pouvant être réglés séparément, à chaque fois pour le réglage séparé de la phase et de l'amplitude des signaux qui doivent être amenés au modulateur de la phase et de l'amplitude.

8. Dispositif selon la revendication 6, caractérisé par le fait que le générateur de compensation (18) comporte des moyens de réglage de la phase et de l'amplitude qui comprennent :

- pour chaque paire de bandes latérales à compenser, à chaque fois un module oscillateur (21, 31 ; 22, 32 ; 23, 33) pour engendrer des signaux en sinus et en cosinus dont les fréquences sont égales à un multiple entier de la fréquence de rotation simple ($\omega_m$) de l'échantillon, y compris celle-ci, cependant que chaque module oscillateur comporte des atténuateurs continûment réglables ($34_1$, $34_2$, $34_3$, $34_4$) pour le réglage de l'amplitude nécessaire de chaque signal en sinus et en cosinus, un déphaseur fixé sur 90° (35) qui déduit les signaux en cosinus des signaux en sinus et qui comporte pour chaque atténuateur un inverseur de polarité (36, 37), et :
- des organes additionneurs (40, 42) pour l'addition à chaque fois des signaux en sinus et en cosinus qui sont fournis par les inverseurs de polarité, les signaux de sortie des organes additionneurs étant à chaque fois amenés au modulateur de l'amplitude et de la phase.

9. Dispositif selon la revendication 6, caractérisé par le fait que le générateur de compensation (18) est réalisé sous la forme d'un générateur de fréquences numérique qui engendre les signaux de modulation par la donnée des coefficients correspondants.

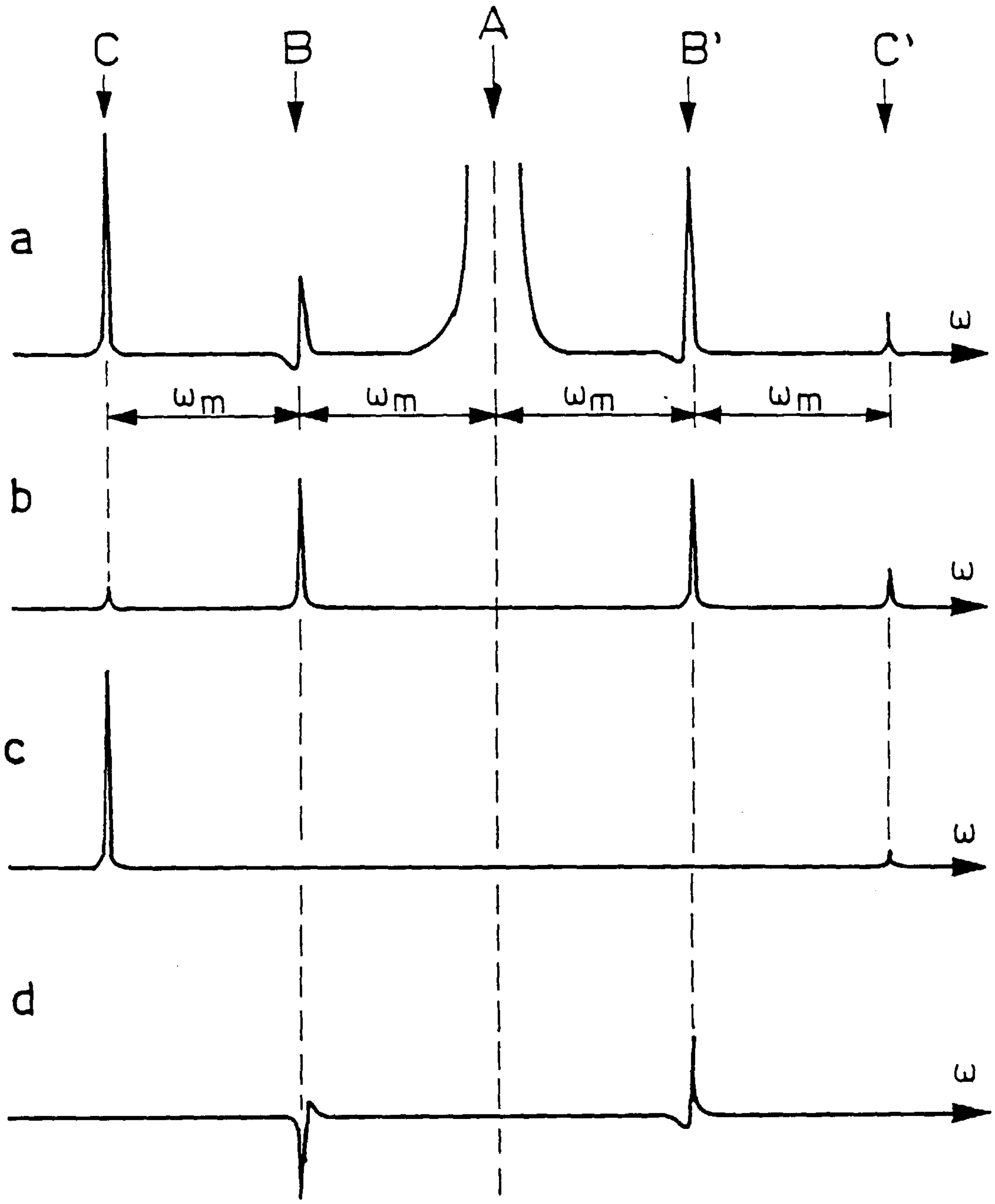


Fig.1

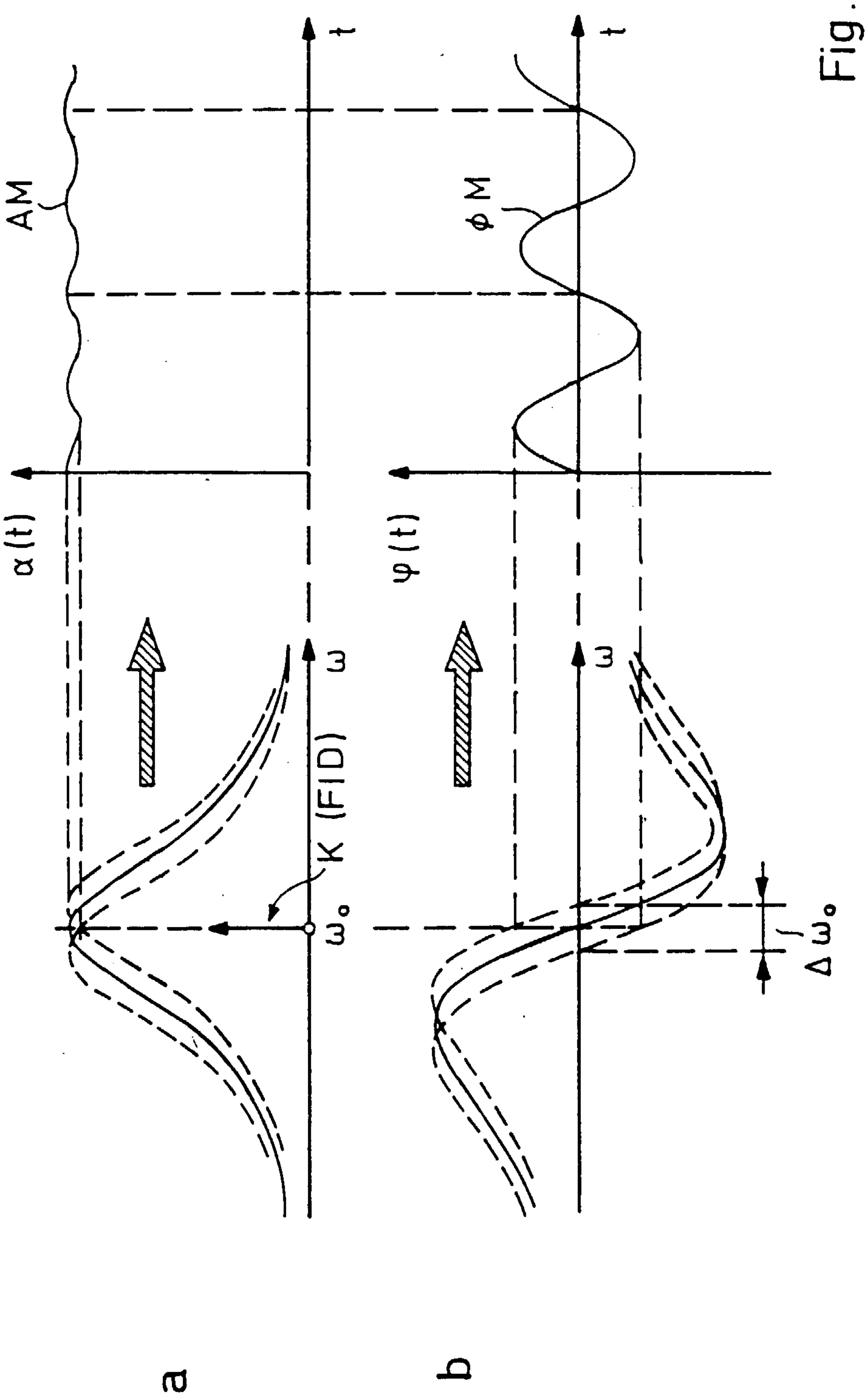


Fig. 2

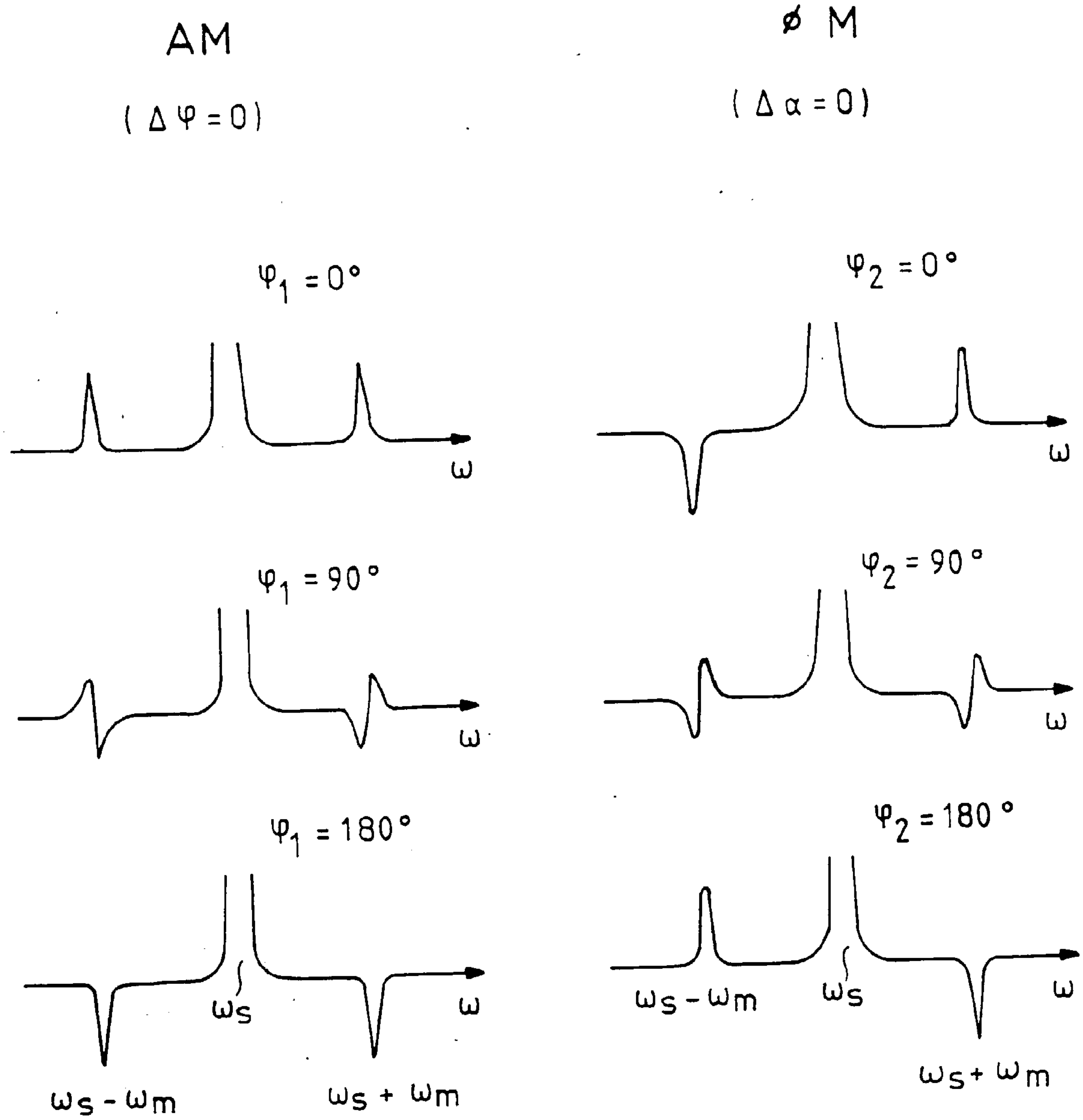
AM
(Δφ=0)
φ1 = 0°
ω
φ1 = 90°
ω
φ1 = 180°
ωs
ω
ωs - ωm
ωs + ωm
ø M
(Δα=0)
φ2 = 0°
ω
φ2 = 90°
ω
φ2 = 180°
ωs - ωm
ωs
ω
ωs + ωm

Fig. 3

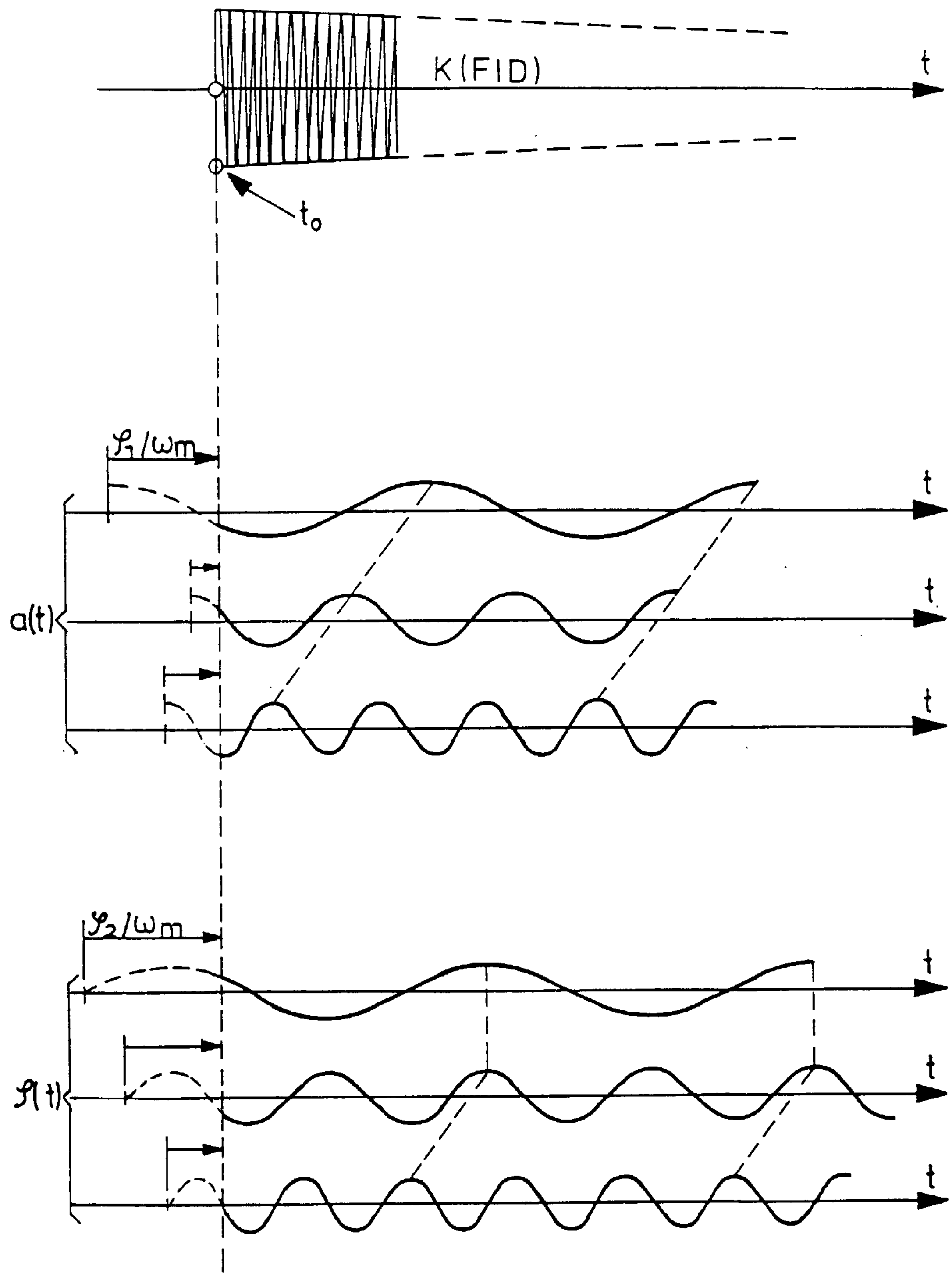


Fig. 4

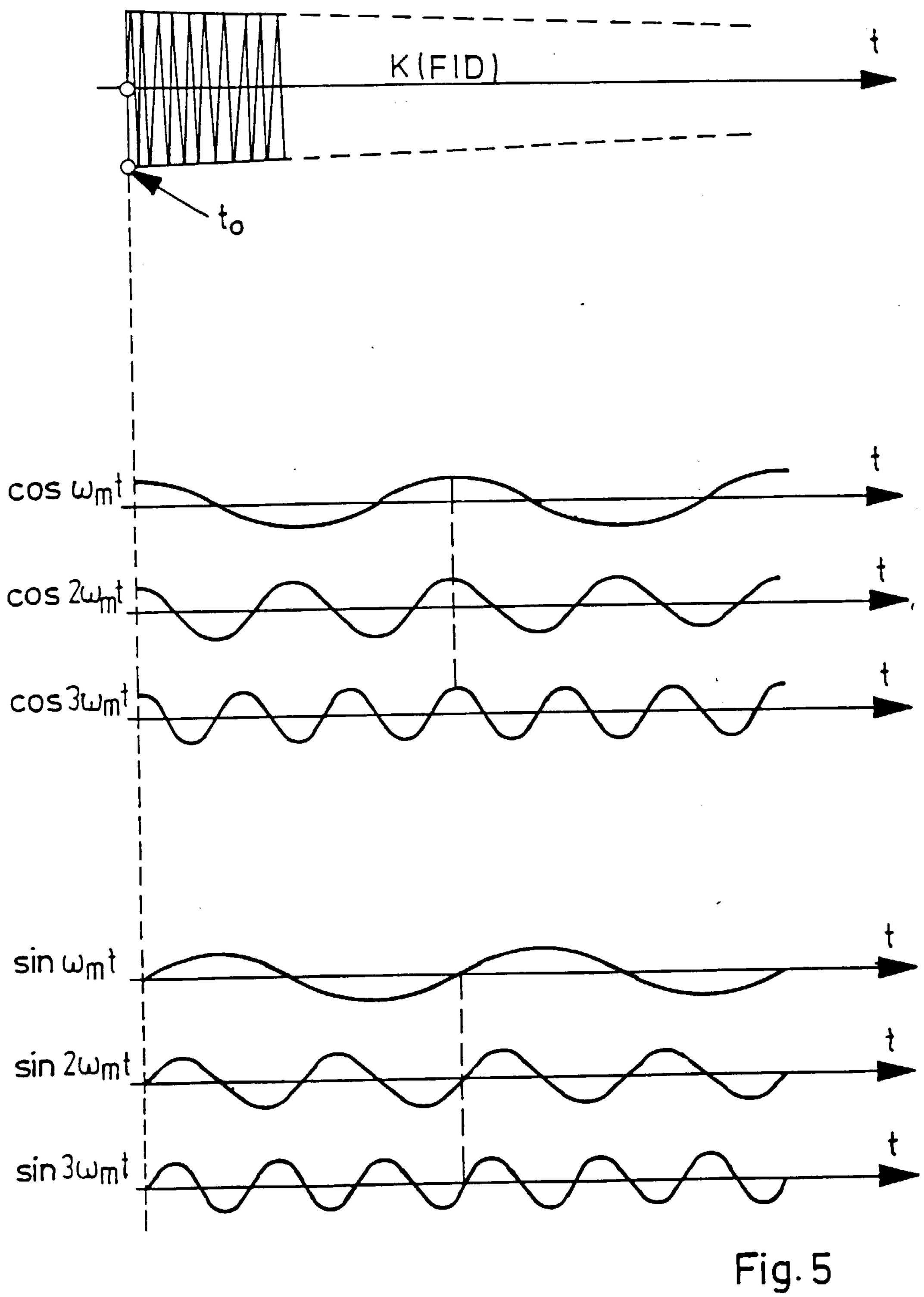
t
K(FID)
$t_o$
cos ωmt
t
cos 2ωmt
t
cos 3ωmt
t
sin ωmt
t
sin 2ωmt
t
sin 3ωmt
t

Fig. 5

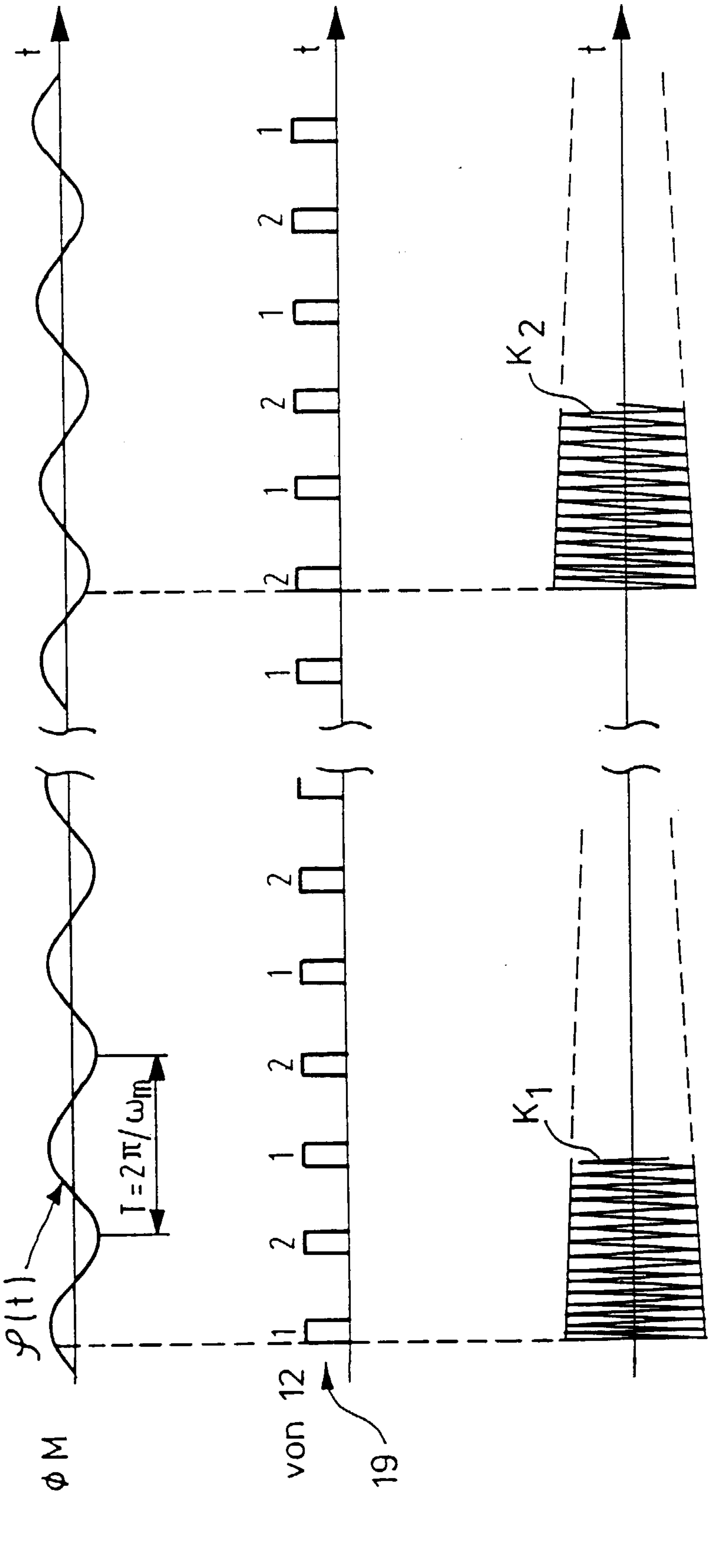


Fig. 6

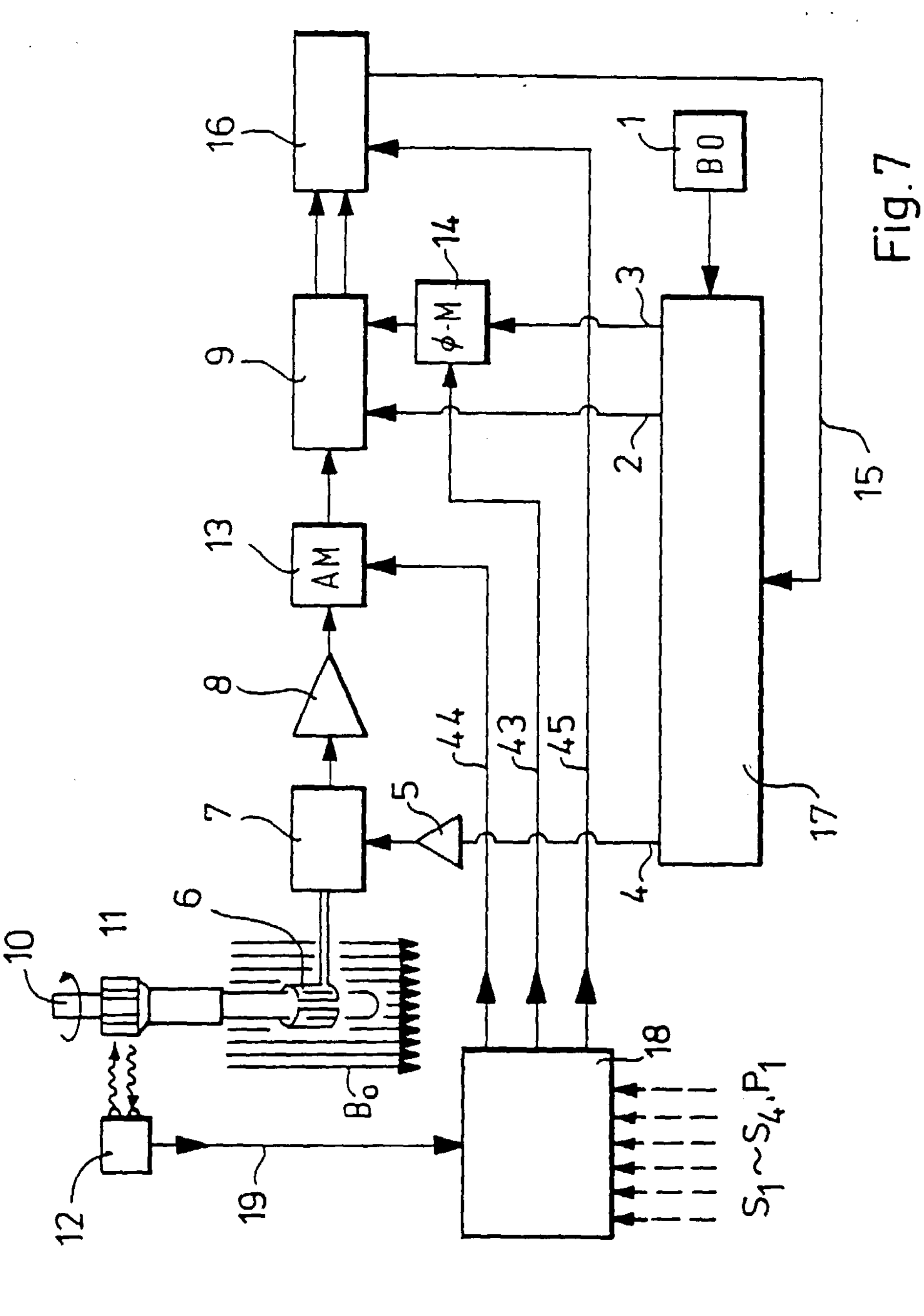

16
9
13
AM
8
7
5
6
10
11
12
19
18
$B_0$
$S_1 \sim S_4, P_1$
44
43
45
4
17
2
3
15
14
φ·M
1
B0


Fig. 7

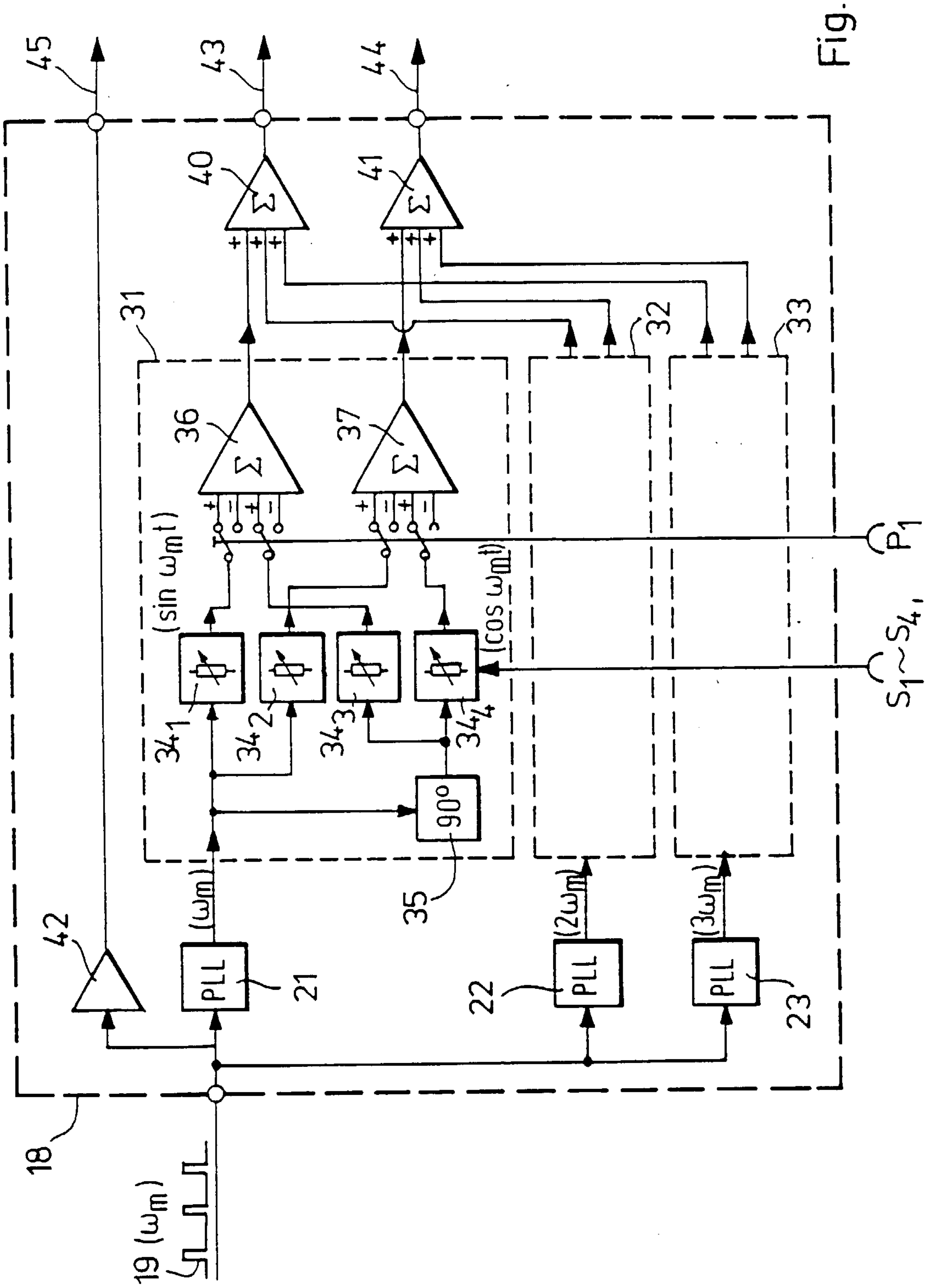

45
43
44
40
41
31
32
33
36
37
(sin ωmt)
(cos ωmt)
34₁
34₂
34₃
34₄
90°
35
42
PLL
21
(ωm)
22
(2ωm)
23
(3ωm)
18
19 (ωm)
S1~S4
P1


Fig. 8